(19) **Europäisches Patentamt**

**European Patent Office**

**Office européen des brevets**

(11) **EP 1 017 086 A1**

(12) **EUROPEAN PATENT APPLICATION**
published in accordance with Art. 158(3) EPC

(43) Date of publication:
05.07.2000 Bulletin 2000/27

(51) Int. Cl.[7]: **H01L 21/027**, G03F 7/20

(86) International application number:
**PCT/JP98/02840**

(21) Application number: **98929682.7**

(22) Date of filing: **25.06.1998**

(87) International publication number:
**WO 98/59364 (30.12.1998 Gazette 1998/52)**

(84) Designated Contracting States:
**AT BE CH CY DE DK ES FI FR GB GR IE IT LI LU MC NL PT SE**

(30) Priority: **25.06.1997 JP 16840697**

(71) Applicant: **Nikon Corporation**
**Tokyo 100-8331 (JP)**

(72) Inventor: **TANAKA, Yasuaki**
**Chiyoda-ku, Tokyo 100-8331 (JP)**

(74) Representative:
**Rackham, Stephen Neil**
**GILL JENNINGS & EVERY,**
**Broadgate House,**
**7 Eldon Street**
**London EC2M 7LH (GB)**

(54) **PROJECTION ALIGNER, METHOD OF MANUFACTURING THE ALIGNER, METHOD OF EXPOSURE USING THE ALIGNER, AND METHOD OF MANUFACTURING CIRCUIT DEVICES BY USING THE ALIGNER**

(57)    The quantity of ultraviolet pulse light (IL) incident on a projection optical system (PL) is measured by means of an integrator sensor (9), and the quantity of ultraviolet pulse light (IL) that has passed through the projection optical system (PL) is measured by means of an irradiation monitor (32). The quantity of transmitted light is divided by the quantity of incident light to calculate the proportion at which the ultraviolet pulse light (IL) is attenuated in the projection optical system (PL), or an attenuation factor. The attenuation factor is determined as a function of the integrated value of the quantity of incident light. During exposure, the integrated value as quantity measured by means of the integrate sensor (9) is substituted into the function to estimate the transmissivity (attenuation factor) of the projection optical system (PL). The output of an excimer law source (1) is controlled according to this attenuation factor to control the exposure thereby preventing lowering of exposure control precision due to illumination variations (or pulse energy variations) on the substrate caused by attenuation variations (transmissivity variations) in the projection optical system.

Fig. 2

## Description

### TECHNICAL FIELD

The present invention relates to a projection apparatus for use in transcribing a pattern on a mask onto a substrate through a projection optical system in a lithography process for manufacturing, for example, semiconductor elements, liquid crystal display elements, thin film magnetic heads, and so on, to a method for manufacturing the projection apparatus, to an exposure method for exposure using the projection apparatus, and to a method for manufacturing circuit devices by using the projection apparatus.

### BACKGROUND OF THE INVENTION

In order to meet with improvements in an extent of integration and a degree of fineness of semiconductor devices, demands have been made to increase characteristics, such as a resolving power and fidelity of transcription, for an exposure apparatus involved in a lithography process (representatively, consisting of a resist coating step, exposing step, and a resist developing step) for manufacturing semiconductor devices. In order to enhance the resolving power and the fidelity of transcription, it is required as the first point that an exposure quality for exposing a resist coated on a water as a substrate to light at an optimal exposure quantity.

Recent years, at plants where semiconductor devices are being manufactured, there have been extensively used a reduced projection exposure apparatus (stepper) of a step-and-repeat type using a reduced projection optical system having a 1/5-fold magnification of projection from a reticle to a wafer, which mainly uses i-rays of a 365 nm wavelength, among brilliant light rays of a mercury discharge lamp, as an exposing illumination light. Further, as the recent trend during these several years, attention has been drawn to a reduced projection exposure apparatus of a step-and-scan type for scanning and exposing an entire image of a circuit pattern of a reticle in each region on the wafer by scanning the reticle at an equal speed in a predetermined direction in a vision field of the reduced projection optical system on its object plane side and by scanning the wafer in the corresponding direction in the vision field of the reduced projection optical system on the image plane side at a speed rate equal to a reduced magnification, in order to avoid that the projection vision field of the reduced projection optical system becomes extremely large as the size (chip size) of the circuit device to be formed on the wafer becomes larger.

For a conventional way of controlling the exposure quality, the exposure quantity on the surface of the wafer is calculated from the light quantity of the illumination light divided in the illumination optical system and the transmittance or transmissivity thereof on the basis of the transmittance or transmissivity of the projection optical system, for example, measured at a certain point of time immediately before exposure, supposed that the transmittance or transmissivity of the projection optical system for the exposing illumination light does not fluctuate in a short time. For a conventional stepper of a step-and-scan type, the output and the scanning velocity of a light source is controlled so as to make the exposure quantity to be calculated a constant value, by controlling the exposing time so as to make an integrated value of the exposure quantity to be calculated a predetermined value.

Recently, in order to improve the resolving power by making the exposing wavelength shorter, projection exposure apparatuses of a step-and-repeat type and projection exposure apparatuses of a step-and-scan type have been developed, which use an ultraviolet pulse light having a wavelength of 250 nm or less from an excimer laser light source as an exposing illumination light. A projection exposure apparatus using a KrF excimer laser light source having a wavelength of 248 nm has started being launched on a large scale in actually manufacturing lines. Moreover, an ArF excimer laser light source emitting an ultraviolet pulse light having a wavelength as short as 193 nm has been developed, and this light source is promising as a future light source for exposure.

If such an ArF excimer laser light source is used as an exposing light source, the wavelength features of the ultraviolet pulse light are required to be narrowed to a wavelength that lacks some absorption bands of oxygen because there are such absorption bands of oxygen in a wavelength band region of the ultraviolet pulse light in its natural oscillation state. Further, it is required that the illumination light path extending from the exposing light source to the reticle and the projection light path extending from the reticle to the wafer are brought each in an environment in which oxygen is contained in the possible least amount, that is to say, that a majority of those illumination light path and projection light path is replaced with an inert gas such as nitrogen gas or helium gas. Examples of the projection exposure apparatuses using such an ArF excimer laser light source are disclosed in, for example, U. S. Patent No. 5,559,584 (corresponding to Japanese Patent Application Laid-Open Nos. 6-260,385 and 6-260,386).

There are currently known only two of optical glass materials having a desired transmittance for an ultraviolet pulse light (having a wavelength of about 250 nm or shorter) from the above-described excimer laser light source, which can be practically applicable. They are quartz ($SiO_2$) and fluorite ($CaF_2$). In addition, there are known, for example, magnesium fluoride and lithium fluoride, but they suffer from the problems with, for example, processing ability and durability in order to allow them to be used as an optical glass material for use with a projection exposure apparatus.

As a projection optical system to be loaded on a projection exposure apparatus, there may also be used a catadioptric type (a reflective-refractive system) consisting of a combination of a refractive optical element (a lens element) with a reflective optical element (particularly a concave mirror), in addition to a dioptric type (a refractive system). Even if a projection optical system of which type, whether a dioptric type or a catadioptric type, is used, however, a refractive optical element (a transmitting optical element) has to be used, and only two kinds of optical glass materials, i.e. quartz or fluorite, have to be used for a refractive optical element at the current time. Moreover, whether a refractive optical element or a reflective optical element is used, a multiple layer film such as a reflection preventive film or a protective layer for example, may be deposited on the surface of such an optical element in order to allow the resulting optical element to demonstrate improved performance to a predetermined extent as a single optical element. The performance that draws particular attention herein is how larger the absolute value of the transmittance of a single body of the lens element or the absolute value of the reflectance or reflectivity of a single body of the reflective optical element can be made.

For instance, for a single body of a lens element, it has been attempted that the transmittance is made as large as possible generally by coating each of the light entering plane and the light leaving plane of the lens element with a reflection preventive film or the like. Moreover, for an precise imaging optical system such as a projection optical system, as many as 20 to 30 lens elements are used for correcting a variety of aberration features to an appropriate extent. Accordingly, even in the event where the transmittance of each lens element is lowered slightly below 100%, the transmittance of the projection optical system as a whole becomes considerably low, so that an attenuation factor of the projection optical system as a whole becomes considerably larger. Further, for a projection optical system containing some reflection optical elements, too, the transmittance of the entire projection optical system becomes low, on the one hand, and the attenuation factor of the entire projection optical system becomes considerably large, on the other, when the reflectance of each of the reflective optical elements is low.

For instance, when it is supposed that the imaging light path of an projection optical system is composed of twenty-five lens elements and the transmittance of each lens element is set to be 96%, the transmittance $\varepsilon$ of the projection optical system as a whole becomes as low as 36% ($\fallingdotseq 0.96^{25}$ x 100). In cases where the transmittance of the projection optical system is low, the exposing time may become so longer that a throughput may be decreased unless measures would be taken that the intensity (energy) of an illumination light for exposing the image of a circuit pattern of a reticle to a wafer is increased or that a resist for ultraviolet rays having a higher sensitivity is used. Therefore, it is considered that an excimer laser light source having a higher output is prepared as measures that can be realized on the side of the projection optical system.

Some experiments made by a projection optical system using an excimer laser light source and having a relatively large field size reveal a new phenomenon, however, has been found that the transmittance of an optical element within a projection optical system or a coating material of an optical element, including, for example, a thin film, such as a reflection preventive film or the like, fluctuates dynamically in a short time by irradiation with an illumination light having an ultraviolet wavelength region, such as KrF excimer laser light or ArF excimer laser light. It has further been found from the results of the experiments that this phenomenon occurs in the entirely equal manner for an optical element in the illumination optical system for illuminating a reticle or for a reticle (made of a quartz plate) itself, as well as for an optical element in a projection optical system.

It is considered that a such phenomenon may occur due to the attachment of impurities to the surface of an optical element or contamination of the illumination light path with such impurities or floating of such impurities in the illumination light path, the such impurities being contained in a gas (air, oxygen gas, etc.) present in a space within a projection light path or a projection light path or the such impurities (e.g., water molecules, hydrocarbon molecules, other substances diffusing the illumination light, etc.) being derived from molecules of organic substances, adhesive or the like for fixing an optical element to a lens barrel, or from the inner wall (i.e., a coated surface for preventing the reflection of light, etc.) of a lens barrel. As a consequence, some drawbacks may occur in that the transmittance (the attenuation factor) of the projection optical system or the transmittance (the attenuation factor) of the illumination optical system fluctuates to a relatively large extent.

For instance, if the transmittance of each lens element would be lowered by 1% for the above-mentioned projection optical system being composed of twenty-five lens elements and having the transmittance $\alpha$ of the entire projection optical system as low as approximately 36%, as in the manner as described above, the transmittance $\varepsilon$ of the projection optical system as a whole becomes lowered to a level as low as approximately 27.7% ($\fallingdotseq 0.95^{25}$ x 100).

There is the risk, however, that the fluctuation of the transmittance of an optical element may vary the exposure quantity to be provided on the wafer from its optimal value and deteriorate in the fidelity of transcribing a fine pattern having a design line width as fine as approximately 0.25 to 0.18 micron to be transcribed on the wafer. As disclosed in Japanese Patent Application Laid-Open No. 2-135,723 (corresponding to U. S. Patent No. 5,191,374), a conventional projection exposure apparatus is configured such that the light intensity of the pulse light (an energy per pulse) from an excimer laser light source is adjusted so as to provide an optimal exposure quantity on the basis of the light intensity of the illumination light detected at a predetermined position in a light path of the illumination optical system. From this configuration, such a conventional projection exposure apparatus has the risk that the exposure quantity cannot be controlled accurately because the fluctuation in the transmittance of the illumination optical system and the projection optical system behind the portion in the illumination light path at which the light intensity of the illumination light is being detected for controlling the exposure quantity.

When the irradiation of the projection optical system with an ultraviolet pulse light is suspended, a phenomenon is being found such that the transmittance of the projection optical system becomes recovered or fluctuating gradually. In such a case, if the exposure is resumed by starting the re-irradiation of an ultraviolet pulse light, there is the risk that the accurate control of the exposure quantity becomes difficult because the transmittance of the projection optical system fluctuates.

SUMMARY OF THE INVENTION

From the foregoing background, the present invention has the primary object to provide a projection exposure apparatus and a method for manufacturing the same, the projection exposure apparatus being configured such that the deterioration in the precision of controlling the exposure quantity is prevented, the deterioration being caused to occur by the fluctuation in illuminance or the fluctuation in energy on a substrate resulting from a fluctuation in the transmittance of the projection optical system.

Further, the present invention has a second object to provide an exposure method that can achieve a favorable precision in controlling the exposure quantity by using such a projection exposure apparatus.

Moreover, the present invention has a third object to provide a method for manufacturing a circuit device that can form a circuit pattern on a substrate with a high fidelity of transcription by using such a projection exposure apparatus.

The projection exposure apparatuses according to the present invention is configured such that a pattern formed on a mask is irradiated with an exposing energy beam and an image of the pattern formed on the mask is projected onto a substrate through a projection optical system, the projection exposure apparatus being provided with an attenuation factor characteristic storage system for storing a fluctuation or variation in an attenuation factor of the projection optical system in accordance with a total entered energy entering into the projection optical system and with an attenuation factor acquisition system for acquiring an attenuation factor of the projection optical system at the time of exposure on the basis of the value of the total entering energy and the fluctuation or variation in the attenuation factor stored in the attenuation factor characteristic storage system by calculating the total entered energy entering into the projection optical system through the mask.

The fluctuation or variation in the attenuation factor is a function of the value of the total entered energy entering into the projection optical system through the mask. The total entered energy entering into the projection optical system can be calculated through the mask on the basis of the transmittance of the mask.

The projection exposure apparatus may be of a type that can project an image of the pattern formed on the mask onto a substrate by scanning the mask relative to the exposing energy beam.

The total entered energy entering into the projection optical system through the mask may also be calculated by taking advantage of information of the relative positions between the exposing energy beam and the mask. The information on the relative positions is an optical characteristic of the mask in accordance with the relative positions of the exposing energy beams and the mask, and the optical characteristic of the mask contains a transmittance characteristic of the mask.

The projection exposure apparatus according to the present invention may further be provided with an entering energy measurement system for measuring the total entered energy entering into the projection optical system through the mask. In addition, the projection exposure apparatus may further be provided with a leaving energy measurement system for measuring a leaving energy leaving from the projection optical system. Moreover, the fluctuation or variation in the attenuation factor may be measured on the basis of a result of measurement by means of the entering energy measurement system and the leaving energy measurement system. The projection exposure apparatus may further be provided with an exposure control system for controlling the exposure quantity to be provided on the substrate on the basis of the fluctuation in the attenuation factor.

The attenuation factor characteristic storage system may be configured so as to store the fluctuation or variation in the attenuation factor of the projection optical system in the elapse of time after the suspension of the irradiation of the projection optical system with the exposing energy beam, in addition to the attenuation factor of the projection optical system for the total entering energy.

As the exposing energy beams, there may be used energy beams having a wavelength of an ultraviolet region.

When a dioptric type (a refractive system) is used as a projection optical system PL, the variation in the transmittance of the lens element mainly exerts influence greatly upon the optical characteristics of the projection optical system PL and causes fluctuating in the attenuation factor of the projection optical system PL. On the other hand, when a catadioptric type (a reflective-refractive system) is used as a projection optical system PL, the variation in the reflectance of a reflective optical element greatly exerts influence upon the optical characteristics of the projection optical system PL, in addition to the variation in the transmittance of the lens element, and the variation in the transmittance of the lens element and the variation in the reflectance of the reflective optical element may cause fluctuating in the attenuation factor of the projection optical system PL.

The fluctuation or variation in the attenuation factor of the projection optical system PL referred to in the specification is intended to mean a fluctuation or variation in the transmittance, on the one hand, in the case of the projection optical system PL using the dioptric type (refractive system) and to mean a fluctuation or variation in the transmittance and the reflectance, on the other hand, in the case of the projection optical system PL using the catadioptric type (reflective-refractive system).

For the projection exposure apparatus according to the present invention, the attenuation factor of the projection optical system can be assumed with a high precision at a nearly real time by storing the fluctuation or variation in the attenuation factor of the projection optical system as a function of the energy value of the total entered energy entering into the projection optical system, measuring the energy entering into the projection optical system from the start of exposure upon actual exposure, that is, from the start of irradiation with the exposing energy beams, and substituting the energy value for the fluctuation or variation in the attenuation factor of the projection optical system previously stored. Therefore, the precision of controlling the exposure quantity can be prevented from deteriorating, which may be caused by the fluctuation in illuminance or the fluctuation in the pulse energy on the substrate resulting from the fluctuation in the attenuation factor of the projection optical system by controlling the exposure quantity by offsetting the variation in the attenuation factor.

It is further preferred that the attenuation factor characteristic storage system be configured so as to store the fluctuation in the attenuation factor of the projection optical system for an elapse of time after the suspension of the irradiation with the exposing energy beams. This configuration of the system permits the presumption of the variation in the attenuation factor of the projection optical system with high precision, even if the optical characteristics of the projection optical system, such as the transmittance, reflectance and so on, would not be recovered immediately after interruption of the irradiation with the exposing energy beam.

The projection exposure apparatus according to the present invention may further be provided with a stage system for transferring each of a mask or a substrate, thereby scanning the mask and the substrate relative to the projection optical system in synchronization with each other. This means that the present invention is applied to the projection exposure apparatus of a scanning exposure type. In this case, the scanning velocity may also be controlled, in addition to controlling the output of an exposing light source, in order to control the exposure quantity.

The method for manufacturing the projection exposure apparatus according to the present invention is configured such that an image of a pattern formed on a mask is irradiated with a predetermined exposing energy beam and the pattern image thereof is projected onto a substrate through a projection optical system. The method comprises the step of installing an attenuation factor characteristic storage system for storing a fluctuation or variation in the attenuation factor of the projection optical system in accordance with a total entered energy entering into the projection optical system and the step of installing an attenuation factor acquisition system for acquiring the attenuation factor of the projection optical system at the time of exposure on the basis of the value of the total entering energy and the fluctuation or variation in the attenuation factor stored in the attenuation factor characteristic storage system by calculating the total entered energy entering into the projection optical system through the mask.

Moreover, the exposure method according to the present invention is configured such that a pattern formed on a mask is irradiated with a predetermined exposing energy beam and an image of the pattern of the mask is projected onto a substrate through a projection optical system. The exposure method comprises obtaining a fluctuation or variation in an attenuation factor of the projection optical system in accordance with a total entered energy entering into the projection optical system and obtaining the attenuation factor of the projection optical system on the basis of the value of the total entering energy entering into the projection optical system through the mask and the fluctuation or variation in the attenuation factor.

Upon measuring the attenuation factor of the projection optical system, it is preferred that the exposure quantity of the exposing energy beam for a substrate is controlled on the basis of the attenuation factor obtained by compensating with a rate of the presence of a pattern on a mask or a rate of pattern transmittance of the mask at the time of exposure to a substrate. By controlling the exposure quantity of the exposing energy beam in the manner as described above, an error can be prevented in measuring the attenuation factor of the projection optical system due to an influence of the rate of the presence of the pattern on the mask or the rate of the transmittance through the pattern on the mask.

Further, the method for manufacturing a circuit device according to the present invention is configured such that a predetermined circuit device is manufactured by projecting an image of a pattern formed on a mask onto a substrate through a projection optical system. The method comprises the first step of coating the substrate with a photosensitive material, the second step of exposing an image of a pattern on the mask to the substrate by controlling the exposure quantity for exposure onto the substrate on the basis of an attenuation factor of the projection optical system at the time of exposure, the attenuation factor being obtained on the basis of a fluctuation or variation in the attenuation factor of the projection optical system against a total entered energy entering into the projection optical system through the mask and on the basis of the total entering energy, and the third step of developing an image of the substrate. This method can provide the exposure quantity at an appropriate level in the exposing process so that a fidelity of transcribing a circuit pattern can be improved.

## BRIEF DESCRIPTION OF THE ACCOMPANYING DRAWINGS

Figure 1 is a schematic view showing the configuration of a projection optical system for use in an embodiment of the present invention.

Figure 2 is a configuration view, including a partially function block diagram, showing a state in which an irradiation monitor 32 is transferred into an exposure region of a projection optical system PL in order to measure a transmittance (an attenuation factor) of the projection optical system PL in an embodiment of the present invention.

Figure 3 is a flow chart showing the operation of measuring the transmittance (attenuation factor) of the projection optical system PL and the operation of exposure in accordance with a first embodiment of the present invention.

Figure 4 is a flow chart showing the operation of measuring the transmittance (attenuation factor) of the projection optical system PL and the operation of exposure in accordance with a second embodiment of the present invention.

Figure 5 is a flow chart showing the operation of measuring the transmittance (attenuation factor) of the projection optical system PL and the operation of exposure in accordance with a third embodiment of the present invention.

Figure 6 is a view showing an example of a variation in the transmittance (attenuation factor) of the projection optical system PL after the suspension of the irradiation with an ultraviolet pulse light to be measured in the third embodiment of the present invention.

Figure 7 is a flow chart showing an example of a process for forming a circuit pattern, in accordance with the third embodiment of the present invention.

## BEST MODES FOR CARRYING OUT THE INVENTION

A description will be made of the projection optical system in accordance with the first embodiment of the present invention with reference to the accompanying drawings. In this embodiment, the present invention is applied to the case where the exposing operation is carried out by using a projection optical system of a step-and-scan type.

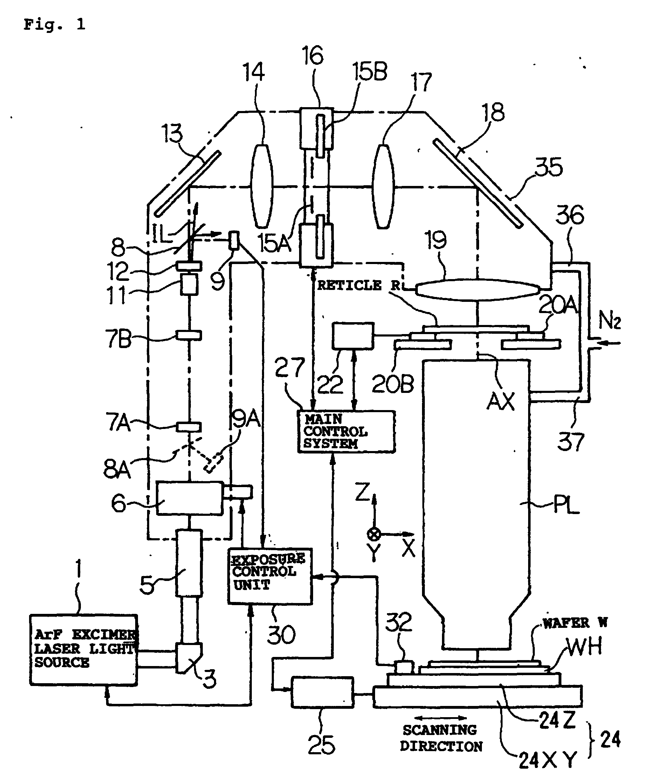

Figure 1 shows a schematic view of the configuration of the projection optical system in this embodiment of the present invention. As shown in Figure 1, an ultraviolet pulse light IL emitting from an ArF excimer laser light source 1, which is narrow-banded at a wavelength of 193 nm, is used as an exposing light. The ultraviolet pulse light IL is arranged so as to pass through a beam matching unit (BMU) 3, containing a movable mirror and so on, which can match the position of a light path with the main body of the projection optical system, and to enter through a light shielding pipe 5 into a variable extinction device 6 as a light attenuator. An exposure control unit 30 for controlling the exposure quantity of a resist on a wafer is configured so as to control the start and the suspension of emission of the ArF excimer laser light source 1 and an oscillation frequency thereof, and an output determined by pulse energy as well as to adjust an extinction factor of the variable extinction device 6 for an ultraviolet pulse light in a stepwise or continuous manner. The present invention may also be applied to the cases where a KrF excimer laser light having a wavelength of 248 nm or a laser light having other wavelength region of less than approximately 250 nm is used as an exposing light.

The ultraviolet pulse light IL passed through the variable extinction device 6 enters into a flyeye lens 11through a beam shaping optical system consisting of lens systems 7A and 7B, the lens systems 7A and 7B being disposed along a predetermined light axis. Although the flyeye lens 11 of a one stage is used in this embodiment in the manner as described above, flyeye lenses in two stages may also be disposed in a row as disclosed, for example, in Japanese Patent Application Laid-Open No. 1-235,289 (corresponding to U. S. Patent No. 5,307,207), in order to enhance a uniformity of the distribution of illuminance. On the light leaving plane of the flyeye lens 11 is disposed an opening stop system 12 for an illumination system. The opening stop system 12 comprises a circular opening stop for usual illumination, an opening stop for modified illumination consisting of plural small eccentric openings, an opening stop for annular illumination, and so on, those opening stops being disposed so as to be shifted. The ultraviolet pulse light IL left from the flyeye lens 11 and passed through a given opening stop in the opening stop systems 12 enters into a beam splitter 8 having a high attenuation factor and a low reflectance. The ultraviolet pulse light reflected by the beam splitter 8 enters into an integrator sensor 9 consisting of photoelectrical detectors, and signals detected by means of the integrator sensor 9 is transmitted to the exposure quantity control unit 30.

The transmittance and reflectance of the beam splitter 8 are measured with high precision in advance and stored in a memory installed in the exposure quantity control unit 30. The exposure quantity control unit 30 is configured so as to monitor a light quantity of the ultraviolet pulse light IL entering into the projection optical system PL and its integrated value indirectly on the basis of the signals detected by means of the integrator sensor 9. In order to monitor the light quantity of light entering into the projection optical system PL, a beam splitter 8A may be disposed, for example, in front of a lens system 7A, as indicated by two-digit chain line in Figure 1, to allow a photoelectrical detector 9A to receive the reflected light reflected from the beam splitter 8A and to transmit signals detected by the photoelectrical detector 9A to the exposure quantity control unit 30.

The ultraviolet pulse light IL transmitted through the beam splitter 8 enters into a fixed illumination vision field stop (fixed blind) 15A disposed in a reticle blind mechanism 16 through a condenser lens system 14. The fixed blind 15A has an opening portion disposed so as to extend in the form of a linear slit or in a rectangular form (hereinafter referred to collectively as "slit form" or a related term) in the direction intersecting at a right angle with the scanning exposure direction in the center within a circular vision field of the projection optical system PL, as disclosed in Japanese Patent Application Laid-Open No. 4-196,513 (corresponding to U. S. Patent No. 5,473,410) for example. In addition to the fixed illumination vision field stop 15, the reticle blind mechanism 16 is provided with a movable blind 15B for changing the width of an illumination vision field region in its scanning exposure direction, thereby reducing a stroke for scanning and transferring a reticle stage by means of the movable blind 15B and making the width of a light shielding band of a reticle R. The information on a rate of an opening of the movable blind 15B is transmitted to the exposure quantity control unit 30, and an actual light quantity of the light entering into the projection optical system PL is equal to a value obtained by multiplying the light quantity by the opening rate, the light quantity being obtainable from signals detected by the integrator sensor 9.

The ultraviolet pulse light IL is shaped in a slit form by means of a fixed blind 15A of the reticle blind mechanism 16, and an illumination region on a circuit pattern region of the reticle R is irradiated with the slit-shaped ultraviolet pulse light IL at a uniform distribution of light intensity through an imaging lens system 17, a reflecting mirror 18 and a main condenser lens system 19, the illumination region being similar in shape to a slit-shaped opening portion of the fixed blind 15A. More specifically, the plane on which the opening portion of the fixed blind 15A or the opening portion of the fixed blind 15B is disposed is constructed so as to become nearly conjugated with a pattern plane of the reticle R in association with a combination system of the imaging lens system 17 with the main condenser lens system 19.

Upon irradiation with the ultraviolet pulse light IL, an image of the circuit pattern within the illumination region of the reticle R is transcribed onto a slit-shaped exposure region of a resist layer on a wafer W disposed on an imaging plane of the projection optical system PL at a given projection magnification $\beta$ ($\beta$ being 1/4 or 1/5 for example) through the projection optical system PL telecentric at both ends. The exposure region is located on a one shot area among plural shot areas on the wafer W. The projection optical system PL for use in this embodiment of the present invention is of a dioptric type (a refractive system), but it is needless to say that the projection optical system of a catadioptric type (a reflective-refractive system) can be used in substantially the same manner. The projection optical system PL will be described in more detail by defining the axis parallel to the light axis AX of the projection optical system PL as a Z-axis, the axis extending in the scanning direction on the flat plane, i.e., the direct ion parallel to the paper plane of Figure 1 in this embodiment), perpendicular to the Z-axis as an X-axis, and the axis extending in the non-scanning direction intersecting at a right angle with the scanning direction, i.e., the direction perpendicular to the paper plane of Figure 1 in this embodiment), as a Y-axis.

Upon irradiation with the ultraviolet pulse light IL, the reticle R is held and adsorbed on a reticle stage 20A that is loaded on a reticle base 20B so as to be movable minutely at an equal velocity in an X-axial direction, in a Y-axial direction, and in a rotational direction. A two-dimensional position and a rotational angle of the reticle stage 20A (reticle R) are measured on a real time basis by means of a laser interferometer disposed in a drive control unit 22. A drive motor (a linear motor, a voice coil motor for example) disposed in the drive control unit 22 is operated to control the scanning velocity and the position of the reticle stage 20A on the basis of the results of this measurement and control information from a main control system 27 consisting of a computer for managing and controlling the operation of the entire apparatus.

On the other hand, the wafer W is held and adsorbed on a Z-tilt stage 24Z by the aid of a wafer holder WH, and the Z-tilt stage 24Z is fixed on an XY stage 24XY disposed so as to move in a two-dimensional direction along an XY plane parallel to an image plane of the projection optical system PL. A wafer stage 24 comprises the Z-tilt stage 24Z and the XY stage 24XY. The Z-tilt stage 24Z may be configured so as to align the surface of the wafer W with the image plane of the projection optical system PL in an auto focus system and at an auto leveling system by controlling the focus position of the wafer W (the Z-axial directional position) and the angle of inclination thereof. On the other hand, the XY stage 24XY may be configured so as to scan the wafer W in the X-axial direction at an equal velocity and move it in a stepwise way in the X-axial direction and in the Y-axial direction. Moreover, the two-dimensional position and the rotational angle of the Z-tilt stage 24Z (wafer W) can be measured at a real time by means of a laser interferometer disposed in a drive control unit 25. A drive motor (a linear motor for example) disposed in the drive control unit 25 is operated to control the scanning velocity and the position of the XY stage 24XY on the basis of the results of this measurement and control information from the main control system 27. An error in the rotation of the wafer W can be corrected by rotating the reticle stage 20A by means of the main control system 27 and the drive control unit 22.

The main control system 27 is configured such that a variety of information including the position of each of the reticle stage 20A and the XY stage 24XY transferred, the transferring velocity, the transferring acceleration, the position offset, and so on is transmitted to the drive control units 22 and 25. Upon scanning exposure, the reticle R is scanned in the +X-axial direction (or -X-axial direction) with respect to the illumination region of the ultraviolet pulse light IL by the aid of the reticle stage 20A at a velocity Vr. On the other hand, the wafer W is scanned in the -X-axial direction (or +X-axial direction) with respect to the exposure region for the pattern image of the reticle R by the aid of the XY stage 24XY at a velocity $\beta$ x Vr (wherein $\beta$ is the magnification of projection onto the wafer W from the reticle R) in synchronization with the scanning of the reticle R.

The main control system 27 controls each blade of the movable blind 16B disposed in the reticle blind mechanism 16 so as to move in synchronization with the movement of the reticle stage 20A upon scanning exposure. Further, the main control system 27 sets a variety of exposing conditions for implementing the scanning exposure of a resist on each shot area on the wafer W at an optimal exposure quantity and executes an optimal exposure sequence even in association with the exposure quantity control unit 30. More specifically, once an instruction is given from the main control system 27 to the exposure quantity control unit 30 that the scanning exposure to a one shot area on the wafer W be started, the exposure quantity control unit 30 starts emitting a laser light from the ArF excimer laser light source 1 and calculating the integrated value of the entering light quantity of the light entering into the projection optical system PL through the integrator sensor 9, the integrated value being reset to zero upon the start of the scanning exposure. Then, the exposure quantity control unit 30 calculates a transmittance (attenuation factor) of the projection optical system PL from the integrated value of the entering light quantity sequentially in a manner as will be described hereinafter. The output (an oscillation frequency and pulse energy) of the ArF excimer laser light source 1 and the extinction ratio of the variable extinction device 6 are controlled so as to provide an optimal exposure quantity at each point of the resist on the wafer W after the start of the scanning exposure, in accordance with the transmittance (attenuation factor) calculated. Thereafter, the emission of the ArF excimer laser light source 1 is suspended upon termination of the scanning exposure to the shot area involved.

The irradiation monitor 32 consisting of photoelectrical detectors is disposed in the vicinity of the wafer holder WH on the Z-tile stage 24Z, and the irradiation monitor 32 supplies signals detected to the exposure quantity control unit 30. The irradiation monitor 32 has a light recipient surface having a size that allows the projection optical system PL to cover the entire area of the exposure region, and it is configured such that the light quantity of the ultraviolet pulse light IL passed through the projection optical system PL can be measured by driving the XY stage 24XY and setting the light recipient surface thereof at the position at which the exposure region of the projection optical system PL is covered as a whole. In accordance with the embodiment of the present invention, the transmittance (attenuation factor) of the projection optical system PL is measured by means of signals detected by the integrator sensor 9 and the irradiation monitor 32. It can also be noted herein, however, that a sensor for sensing the irregularity of illuminance can be used in place of the irradiation monitor 32, the sensor having a light recipient part in the form of a pin hole for measuring the distribution of the light quantity within the exposure region.

In the embodiment of the present invention, in order to permit the ArF excimer laser light source 1 to be used in an appropriate way, a sub-chamber 35 may be disposed which can shield each illumination light path from open air, each illumination light path extending from the inside of the pipe 5 to the variable extinction device 6 and the lens systems 7A and 7B and from the flyeye lens system 11 to the main condenser lens system 19. To the inside of the sub-chamber 35 as a whole is supplied dry nitrogen gas ($N_2$) through a pipe 36, the nitrogen gas having the oxygen content reduced to an extremely low level. Likewise, such dry nitrogen gas is also supplied through a pipe 37 to spaces as a whole formed among plural lens elements present within a lens barrel of the projection optical system PL, i.e., spaces among the plural lens elements.

If the sub-chamber 35 and the lens barrel of the projection optical system PL are highly airtight, it is not required to supply such dry nitrogen gas so frequently once they have been replenished therein to a full extent. It is necessary, however, that molecules of impurities are being removed by means of a chemical filter or an electrostatic filter while flowing a temperature-controlled nitrogen gas through the light path in a forced manner, when the situation is taken into account that the transmittance (attenuation factor) is caused to fluctuate due to the attachment, etc. of such impurities such as molecules of water, hydrocarbons or the like, resulting from various substances (such as glass materials, coating materials, adhesive, paints, metals, ceramics, etc.) present in the light path to the surfaces of the optical elements.

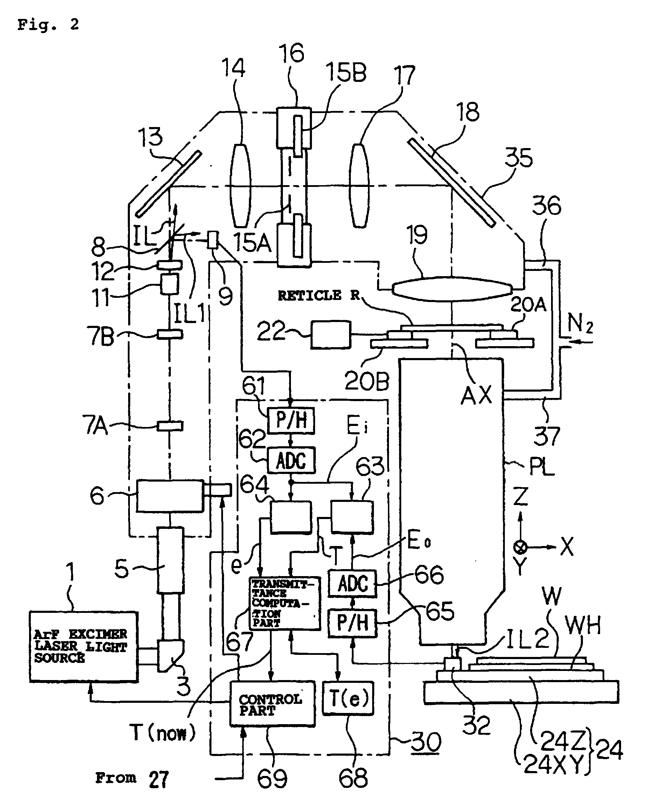

Then, a description will be made of a transmittance (attenuation factor) measurement system of the projection optical system PL disposed in the projection optical system according to the embodiment of the present invention with reference to Figure 2. When the transmittance (attenuation factor) of the projection optical system PL is to be measured, the light recipient surface of the irradiation monitor 32 is set in the exposure region of the projection optical system PL by driving the XY stage 24XY, as shown in Figure 2. Thereafter, the pulse emission of the ArF excimer laser light source 1 is started to emit an ultraviolet pulse light IL that in turn enters onto the beam splitter 8, and a portion of the ultraviolet pulse light IL entered is reflected by the beam splitter 8 and then enters into the integrator sensor 9 as ultraviolet pulse light IL1. The portion of the ultraviolet pulse light IL passed through the projection optical system PL, as ultraviolet pulse light IL2, passed through the projection optical system PL enters into the irradiation monitor 32, and the signals detected by the integrator sensor 9 and the irradiation monitor 32 are incorporated into the exposure quantity control unit 30 in a parallel way.

As shown in Figure 2, the signals detected by the integrator sensor 9 as an entered energy Ei are supplied to a direct transmittance (attenuation factor) computation part 63 for computing a direct transmittance (attenuation factor) and an entered light quantity integration part 64 for integrating the entered light quantity through a peak hold (P/H) circuit 61 and an analog-digital converter (ADC) 62 disposed in the exposure quantity control unit 30. In this embodiment of the present invention, the direct transmittance (attenuation factor) computation part 63 and the entered light quantity integration part 64 as well as a transmittance (attenuation factor) computation part 67 and a control part 69, as will be described hereinafter, are represented as software functions to be executed each by a microprocessor. It is as a matter of course that each function can be realized by means of a hardware.

On the other hand, signals detected by the irradiation monitor 32 for monitoring an irradiation amount are fed to a direct transmittance (attenuation factor) computation part 63 as a transmittance energy Eo through a peak hold circuit 65 and an ADC 66 disposed in the exposure control unit 30, and the direct transmittance (attenuation factor) computation part 63 computes a transmittance (attenuation factor) T (= Eo/Ei) of the projection optical system PL by dividing the transmitted energy Eo by the entered energy Ei, and the transmittance (attenuation factor) T so computed is fed to the transmittance (attenuation factor) computation part 67. On the other hand, the entered light quantity integration part 64 computes a total entered energy e by integrating the entered energy Ei per every entering ultraviolet pulse light, and the computed total entered energy e is fed to the transmittance (attenuation factor) computation part 67. The total entered energy e is reset to zero immediately before the start of the pulse emission. The transmittance (attenuation factor) computation part 67 approximates the transmittance (attenuation factor) T to be supplied by a function (e.g., a higher-order function of the second order or higher, an exponential function, etc.) T(e) of the total entering energy e supplied, and the resulting function T(e) is stored in a memory 68. The transmittance (attenuation factor) computation part 67 further gives a current transmittance (attenuation factor) T(now) of the projection optical system PL by substitution of the total entered energy e to be supplied from the entered light quantity integration part 64 for the function T(e) read from the memory 68 and supplies the resulting transmittance (attenuation factor) T(now) to the control part 69. To the control part 69 is fed the entered energy Ei from the ADC 62, although not shown in the drawings, and the output from the ArF excimer laser light source 1 and the transmittance of the variable extinction device 6 are controlled by the control part 69 so as to adjust the exposure quantity of the ultraviolet pulse light at each point of the resist on the wafer W to an appropriate exposure quantity by taking advantage of the entered energy Ei and the transmittance (attenuation factor) T(now).

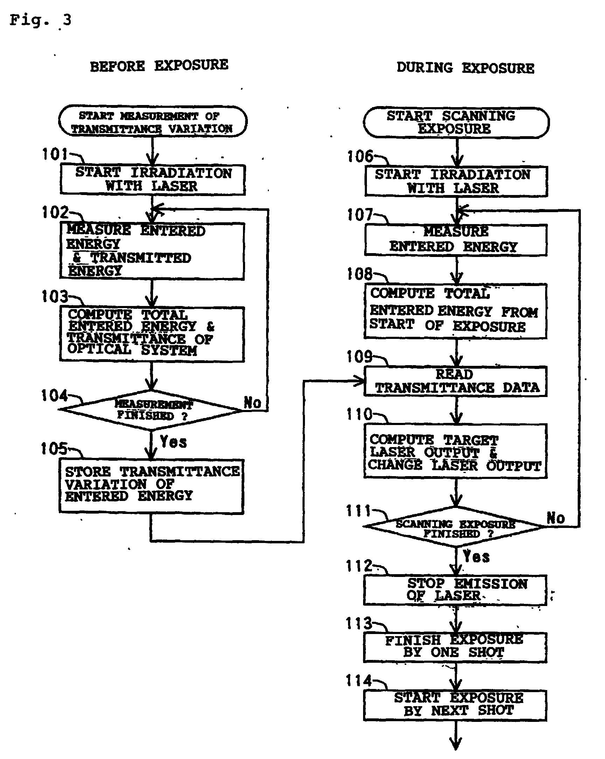

Then, a description will be made of the operation in accordance with the embodiment of the present invention with reference to the flow chart as shown in Figure 3, in which a variation in the transmittance (attenuation factor) of the projection optical system PL is measured and the scanning exposure is carried out while implementing the control over the exposure quantity on the basis of the results of this measurement. The measurement of the transmittance (attenuation factor) is carried out, for instance, at the time of starting the operation of the projection optical system or the exposure operation.

First, at step 101 of Figure 3, the light recipient surface of the irradiation monitor 32 is set in an exposing region of the projection optical system PL, as shown in Figure 2, and the comprehensive opening rates of the fixed blind 15A and the movable blind 15B are set each to be 100%. In this embodiment, the reticle R is detached from the reticle stage 20A, in order to give the relationship of the maximal value of the entered energy entered into the projection optical system PL with the transmittance (attenuation factor), and no scanning by means of the reticle stage 20A is effected. Thereafter, the pulse emission of the ArF excimer laser light source 1 is started.

Then, at step 102, the exposure quantity control unit 30 of Figure 2 creates an entered energy Ei corresponding to the energy entering actually into the projection optical system PL and a transmitting energy Eo corresponding to the energy passing actually through the projection optical system PL by incorporating output signals from the integrator sensor 9 and the irradiation monitor 32 in a parallel manner. Then, the entered light quantity integration part 64 as shown in Figure 2 calculates the then total entered energy e by integrating the entered energy Ei for every pulse emission, and the direct transmittance (attenuation factor) computation part 63 calculates the transmittance (attenuation factor) T (= Eo/Ei). This operation is being executed in a continuous way at every pulse emission until the measurement has been finished. If the exposing light is a continuous light, a sample hold circuit may be used in place of the peak hold (P/H) circuit 61 and the peak hold circuit 65, and the entered light quantity integration part 64 incorporates detected signals one after another at a given sampling rate, while the direct transmittance (attenuation factor) computation part 63 calculates the transmittance (attenuation factor) T at given time intervals.

Further, at step 103, the transmittance (attenuation factor) computation part 67 in the exposure quantity control unit 30 incorporates the total entered energy e and the transmittance (attenuation factor) T at each point of measurement time and at a measurement interval, for instance, that can become sufficiently short in respect of the exposure time for one shot. Thereafter, at step 104, it is decided to learn whether the measurement has been finished or not. Upon this decision, the measurement time is set in such a manner that the total entered energy e at the time of the finish of measurement is set so as to become sufficiently large with respect to the total entered energy to be accumulated during the exposure of one shot. The measurement time may be set to range from several seconds to several 10 seconds. The operation of incorporating (computing) measured data by means of the transmittance (attenuation factor) computation part 67 at step 103 is repeated at given measurement intervals until a predetermined measurement time elapses, and the operation is then shifted from step 104 to step 105, as the predetermined mesurement time has elapsed. Then, at step 105, the transmittance (attenuation factor) computation part 67 computes the transmittance (attenuation factor) T(e) of the projection optical system PL as a function of a series of the total entered energy e and stores the resulting transmittance (attenuation factor) T(e) in the memory 68. This storage is equivalent of storage of a state of a variation in the transmittance (attenuation factor) of the projection optical system PL for the entered energy Ei. The function T(e) of the transmittance (attenuation factor) is used during the scanning exposure at step 109.

Thereafter, when the scanning exposure is carried out by means of the projection optical system of a step-and-scan type, the control of the total entered energy e at the time of the finish of measurement is set to the exposure quantity is effected by controlling the scanning velocity and the light quantity of an exposing light source (including the control of the extinction rate of the variable extinction device 6), unlike the projection optical system of a step-and-repeat type. More specifically, when a certain one point on the wafer is taken as an example, the scanning velocity of the wafer stage 24 and the light quantity of the exposing light source are controlled in such a manner that the certain one point is irradiated with light in a predetermined exposure quantity determined from sensitivity to the resist or the like during a period of time during which the certain point passes through the slit-shaped exposure region of the projection optical system PL.

It is to be noted herein that a reference value of the output per unit time (i.e., an oscillating frequency by a pulse energy) of the ArF excimer laser light source 1 is defined as Eo[W], and the output is set as a value multiplied by an extinction rate of the variable extinction device 6. Further, the initial attenuation factor of the projection optical system PL is set as T0, the area of the slit-shaped exposure region is set as S $[cm^2]$, the length of the scanning direction of the exposure region is set as L [mm], and the sensitivity to the resist is set as I $[J/cm^2]$. Under these conditions, an initial value Vwo [mm/second] of the scanning velocity of the wafer stage 24 upon scanning exposure may be defined by the following formula:

$$Vwo = (L \times E_0 \times T_0)/(I \times S) \qquad (1).$$

Immediately after the start of the scanning exposure, the scanning is effected while maintaining the relationship of the relative positions of the reticle R and the wafer W, in order to allow the wafer stage 24 to move at the scanning velocity as defined above.

More specifically, once the scanning exposure has been started, the reticle R is loaded on the reticle stage 20A as shown in Figure 1 at step 106 of Figure 3, and the wafer W coated with a resist is loaded on the wafer holder WH held on the wafer stage 24. Then, after the total entered energy e is reset to zero in the exposure quantity control unit 30, the scanning of the reticle stage 20A and the wafer stage 24 is started, and the pulse emission of the ArF excimer laser light source 1 is also started at the point of time when the scanning is brought into a synchronous state. At the same time, the incorporation of signals detected by the integrator sensor 9 into the exposure quantity control unit 30 is also started. Thereafter, as the movable blind 15B is gradually opened, and the transcription of an image of a pattern formed on the reticle R onto an involved shot area on the wafer W is started. Comprehensive information on the opening rates of the fixed blind 15A and the movable blind 15B has already been supplied to the entered light quantity integration part 64 as shown in Figure 2.

Then, at step 107, the entered energy Ei at every pulse emission is measured through the integrator sensor 9, the peak hold circuit 61, and the ADC 62, as shown in Figure 2, and the measured entered energy Ei is supplied one after another to the entered light quantity integration part 64. Thereafter, at step 108, the entered light quantity integration part 64 computes the total entered energy e supplied so far by integrating the energy obtained by multiplying the entered energy Ei entered at every pulse emission by the opening rate at that time, and supplies the total entered energy e from the start of the exposure to the transmittance (attenuation factor) computation part 67. Then, at step 109, the transmittance (attenuation factor) computation part 67 calculates the current transmittance (attenuation factor) T(now) of the projection optical system PL at predetermined time intervals by substituting the total entered energy e for the function T(e), i.e., transmittance data, representative of the transmittance (attenuation factor) read from the memory 68, and supplies the calculated transmittance (attenuation factor) T(now) to the control part 69. This computation may be carried out at a frequency as short as possible with respect to the exposure time for one shot. More specifically, during the exposure time for one shot, the computation of the transmittance (attenuation factor) of the projection optical system PL is repeated plural times in order to obtain the current transmittance (attenuation factor) always at a nearly real time.

Next, at step 110, the control part 69 controls the output of the ultraviolet pulse light IL on the basis of the transmittance (attenuation factor) T(now) supplied. In this control, if it is assumed that the scanning velocity Vw of the wafer stage 24 does not vary from the scanning velocity Vwo as defined in the formula (1) above, it is such that the illuminance (energy per unit time or per area) of the ultraviolet pulse light IL on the surface (the wafer surface) of the wafer W is set constant, in order to make the exposure quantity at each point on the wafer W constant. In other words, it is such that the output from the ArF excimer laser light source 1 is varied so as to offset the variation in the transmittance (attenuation factor) T(now) of the projection optical system PL, that is, so as to become inversely proportional to the transmittance (attenuation factor) T(now). More specifically, when the value of the current transmittance (attenuation factor) T(now) of the projection optical system PL at a certain time point t obtained in the manner as described above is indicated as T1, an initial transmittance (attenuation factor) of the projection optical system PL is indicated as T0. and a reference value (an initial value) of the output of the ArF excimer laser light source 1 is indicated as Eo, a target output Et of the ArF excimer laser light source 1 for making the illuminance of the ultraviolet pulse light IL on the wafer surface constant, the target output Et may be obtained as follows:

$$Et = Eo \times (T_0/T_1) \qquad (2).$$

Then, the control part 69 controls the output (the oscillating frequency and the pulse energy) of the ArF excimer laser light source 1 or the extinction rate of the variable extinction device 6 so as to allow the output of the ultraviolet pulse light IL passing through the variable extinction device 6 to reach the target output Et obtained by the formula (2) above. Thereafter, when the scanning exposure is not yet finished at step 111, the operation is returned again to the processes at steps 107 to 110 to repeat the computation of the transmittance (attenuation factor) of the projection optical system PL at predetermined time intervals, the computation of the target output Et of the ultraviolet pulse light IL, and the control of the output of the ArF excimer laser light source 1. Then, as the scanning exposure has been finished, then the operation is shifted from step 111 to step 112 at which the emission from the ArF excimer laser light source 1 is suspended. After the exposure for one shot area has been finished at step 113, the exposure operation for the next shot area is started at step 114. At the time of starting the exposure for the next shot area, the computation of the transmittance (attenuation factor) of the projection optical system PL is started on the assumption that the transmittance (attenuation factor) of the projection optical system PL is recovered almost to the value equal to the initial transmittance (attenuation factor) at step 106.

In accordance with the embodiment of the present invention, the transmittance (attenuation factor) of the projection optical system PL is measured at a nearly real time on the basis of the integrated value of the entered energy entered into the projection optical system PL measured through the integrator sensor 9, and the output of the ArF excimer laser light source 1 is controlled so as to maintain the illuminance of the ultraviolet pulse light IL on the wafer surface at a constant level on the basis of the results of measurement, so that the entire plane of each shot area on the wafer can be exposed at an optimal exposure quantity even if the transmittance (attenuation factor) of the projection optical system PL would vary.

In the embodiment of the present invention as described above, it is to be noted herein that the output of the ArF excimer laser light source 1 is controlled in accordance with the transmittance (attenuation factor) of the projection optical system PL. As is apparent from the formula (1) above, however, the relationship can be established such that the transmittance (attenuation factor) T0 of the projection optical system PL is proportional to the scanning velocity Vwo of the wafer stage 24, if the output Eo of the exposing light source is constant. Therefore, in cases where the current transmittance (attenuation factor) T(now) of the projection optical system PL varies, the scanning velocity of the wafer stage 24 may be controlled in proportion to the current transmittance (attenuation factor) t(now) by maintaining the output of the exposing light source at a constant level. This control, however, can be conducted in the scope in which the scanning velocity does not reach its upper limit defined by the stage system.

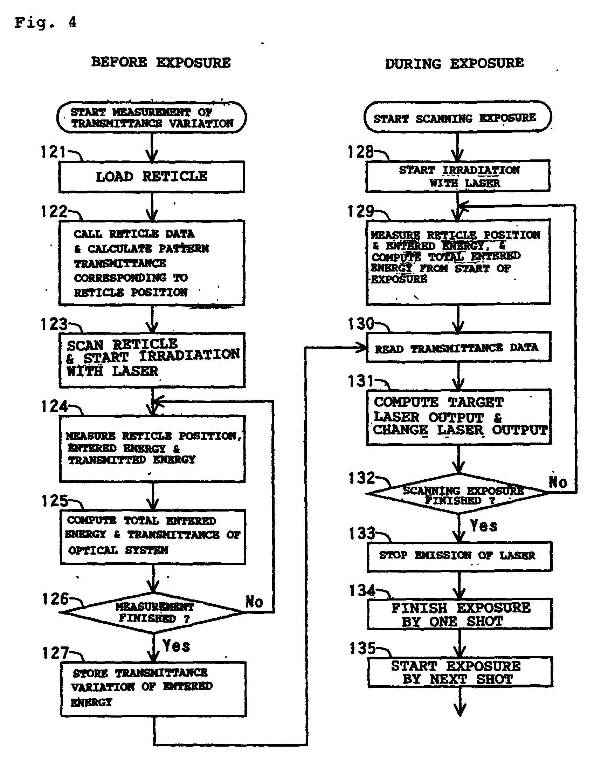

Then, the second embodiment of the present invention will be described hereinafter. In this embodiment, the projection exposure apparatus as illustrated in Figure 1 is used, but the method for the measurement of a variation in the transmittance (attenuation factor) of the projection optical system PL is different from that used for the projection exposure apparatus of Figure 1. Therefore, a description will be made of the operation for measuring the variation in the transmittance (attenuation factor) of the projection optical system PL and the operation for implementing the scanning exposure with reference to the flow chart as illustrated in Figure 4. In this embodiment, a reticle R for use in actual exposure is scanned likewise upon actual exposure, when the variation in the transmittance (attenuation factor) of the projection optical system PL is to be measured. In this case, when the scanning velocity of the reticle stage 20A (reticle R) of Figure 1 upon measurement is referred to as Vm, the output of the ArF excimer laser light source 1 upon measurement is referred to as Em, the scanning velocity thereof upon actual scanning exposure is referred to as Ve, and the output thereof upon actual scanning exposure is referred to as Ee, the relationship can be established among those elements as follows:

$$Vm/Em = Ve/Ee \qquad (3).$$

In other words, the total light quantity entering into the projection optical system PL during scanning the reticle R from the start of scanning to a certain optional position is made as constant at the time of measurement as at the time of scanning exposure. As a matter of course, it is desirable that the scanning velocity of the reticle stage 20A upon measurement, Vm, becomes equal to the scanning velocity thereof upon actual scanning exposure. Ve. Upon measurement, the light quantity entering actually into the projection optical system PL of Figure 2 is set to become a light quantity obtained by multiplying the entered energy Ei measured by means of the integrator sensor 9 by a pattern transmittance of the reticle R (i.e., an area of a transmitting part within the illumination region divided by an area of an illumination region on the reticle R). On the other hand, the pattern transmittance is a value obtained by subtracting a pattern presence rate from 1. Thus, in this case, the pattern presence rate can also be used in place of the pattern transmittance. Moreover, the transmitted energy Eo to be measured through the irradiation monitor 32 is a value obtained by multiplying the entered light quantity by the pattern transmittance of the reticle R and the transmittance (attenuation factor) of the projection optical system PL. The pattern transmittance referred to herein is known from design data of the reticle R as a function of the position X of the reticle R, and the transmittance (attenuation factor) of the projection optical system PL is an object to be provided. When the entered energy Ei to be measured through the integrator sensor 9 is referred to as Ei, the transmitted energy to be measured through the irradiation monitor 32 is referred to as Eo, the pattern transmittance of the reticle R is referred to as a function TR(X) of the position X, and the transmittance (attenuation factor) of the projection optical system PL is referred to as T, the transmittance (attenuation factor) T of the projection optical system PL can be given from the formula as follows:

$$T = (1/TR(X)) \times (Eo/Ei) \qquad (4).$$

More accurately, the function TR(X) of the pattern transmittance is multiplied by overall opening rates of the fixed blind 15A and the fixed blind 15B.

Therefore, at step 121 of Figure 4, the light recipient surface of the irradiation monitor 32 is set in the exposure region of the projection optical system PL (as shown in Figure 2), and the reticle R is loaded on the reticle stage 20A. The reticle stage 20A is then transferred to the position from which the scanning is started. Thereafter, at step 122, the design data (reticle data) of the reticle R is called, for example, from a host computer, although not shown, by means of the main control system 27 as shown in Figure 1, and the pattern transmittance TR(X) corresponding to the position X of the reticle R in its scanning direction is calculated. Then, at step 123, the scanning of the reticle stage 20A (reticle R) is started in response to an instruction from the main control system 27 in the same manner as upon actual exposure. At the same time, the emission of the ArF excimer laser light source 1 is started. The reticle R is then scanned in the +X-axial direction or in the -X-axial direction up to the position at which the scanning is to be finished.

Further, at step 124, the position X of the reticle stage 20A measured through the drive control unit 22 is supplied to the main control system 27, the entered energy Ei to be measured through the integrator sensor 9 at every pulse emission is supplied to the direct transmittance (attenuation factor) computation part 63 and the entered light quantity integration part 64. Moreover, the transmitted energy Eo measured through the irradiation monitor 32 is supplied to the direct transmittance (attenuation factor) computation part 63. Then, at step 125, the main control system 27 calculates the current pattern transmittance TR(X) from the position X of the reticle stage 20A at a cycle shorter than an emission cycle, and the results of calculation are supplied to the direct transmittance (attenuation factor) computation part 63 and the entered light quantity integration part 64. The entered light quantity integration part 64 calculates the total entered energy e by integrating a value obtained by multiplying the entered energy Ei at every pulse emission by the pattern transmittance TR(X), and supplies the integrated value to the transmittance (attenuation factor) computation part 67. On the other hand, the direct transmittance (attenuation factor) computation part 63 calculates the transmittance (attenuation factor) T of the projection optical system PL by substitution of the entered energy Ei and the transmitted energy Eo for the formula (4) as indicated above, and supplies the results of computation to the transmittance (attenuation factor) computation part 67. Further, at step 126, the operation of step 125 is repeated at predetermined time intervals until the measurement is finished at step 126, that is, until the reticle R is transferred up to the position at which the scanning of the reticle R is to be finished. When the measurement has been finished, the process is moved to step 127 at which the transmittance (attenuation factor) computation part 67 gives the transmittance (attenuation factor) T of the projection optical system PL T as a function T(e) of the total entered energy e. The function T(e) is then stored in the memory 68.

Thereafter, when the actual scanning exposure is to be implemented, the scanning of the reticle R and the wafer W, as illustrated in Figure 1, is started at step 128 in substantially the same manner as at step 106 of Figure 3, to start the emission from the ArF excimer laser light source 1. Then, at step 129, the position X of the reticle R is measured by the drive control unit 22 at a predetermined cycle, and the entered energy Ei is measured by the integrator sensor 9 at every pulse emission. Moreover, the pattern transmittance TR(X) calculated from the position X of the reticle R is supplied to the entered light quantity integration part 64 as shown in Figure 2, and the entered light quantity integration part 64 calculates the total entered energy e by integrating a value obtained by multiplying the entered energy Ei by the pattern transmittance TR(X), and the results of computation are supplied to the transmittance (attenuation factor) computation part 67. At step 130, the transmittance (attenuation factor) computation part 67 computes the current transmittance T(now) of the projection optical system PL by substitution of the total entered energy e for the function T(e) stored in the memory 68 at step 127 and supplies the results of computation to the control part 69. Then, the control part 69 controls the output of the ArF excimer laser light source 1 or the extinction rate of the variable extinction device 6 so as to maintain the illuminance of the ultraviolet pulse light IL on the wafer W at a constant level by offsetting the fluctuation in the transmittance (attenuation factor) of the projection optical system PL in substantially the same manner as at step 110. Thereafter, steps 132 to 135 are executed in substantially the same manner as steps 111 to 114, respectively, to conduct the scanning exposure for the shot area and to prepare for the exposure of the next shot area.

In accordance with this embodiment, the pattern transmittance of the reticle is taken into account, so that the fluctuation in the transmittance (attenuation factor) of the projection optical system PL upon actual scanning exposure can be detected with higher precision. Therefore, the precision of the control of the exposure quantity can be improved.

Although the reticle R is scanned in an optional direction upon measurement of the transmittance (attenuation factor) in this embodiment, there is the risk that the form of the function T(e) representative of the transmittance (attenuation factor) of the projection optical system PL may be varied in a subtle way in a certain direction in which the reticle R is scanned. Therefore, the function T1(e) and T2(e) for the respective scanning direction may be given, and the functions T1(e) and T2(e) may be used properly in accordance with the scanning direction upon scanning exposure. This allows the exposure quantity to be controlled with high precision, for instance, in cases where the pattern transmittance of the reticle is not symmetric or where the transmittance of a substrate itself for the reticle is not symmetric.

Now, a description will be made of the third embodiment of the present invention. In this embodiment, too, the projection exposure apparatus as shown in Figure 1 is used. In this embodiment, however, the fluctuation in the transmittance (attenuation factor) of the projection optical system PL is measured even after suspension of the irradiation with the ultraviolet pulse light IL. In other words, in the first and second embodiments as described above, a variation in the transmittance (attenuation factor) of the projection optical system PL is given simply with the irradiation only at every single scanning exposure taken into account, with the assumption that the transmittance (attenuation factor) of the projection optical system PL is returned to its initial state immediately after suspension of the irradiation with the ultraviolet pulse light IL. There is the possibility, however, that the transmittance cannot be recovered to its initial state to a sufficient extent until exposure at a next shot is to be started, after exposure at a certain one shot, depending upon the velocity recovering after suspension of the irradiation with the ultraviolet pulse light IL. In particular, in cases where a low sensitive resist is used, the transmittance may be varied to a large extent because a larger exposure quantity is required, so that the transmittance may become unlikely to be recovered to its initial state between shots for exposure. Further, even in cases where the stepping time between shots or other conditions are to be shortened in order to improve a throughput of the projection exposure apparatus, the risk may be caused to occur that the transmittance fails to be recovered to a sufficient extent between shots for exposure, so that it is required that the fluctuation in the transmittance (attenuation factor) after suspension of the irradiation with the ultraviolet pulse light IL has to be taken into consideration.

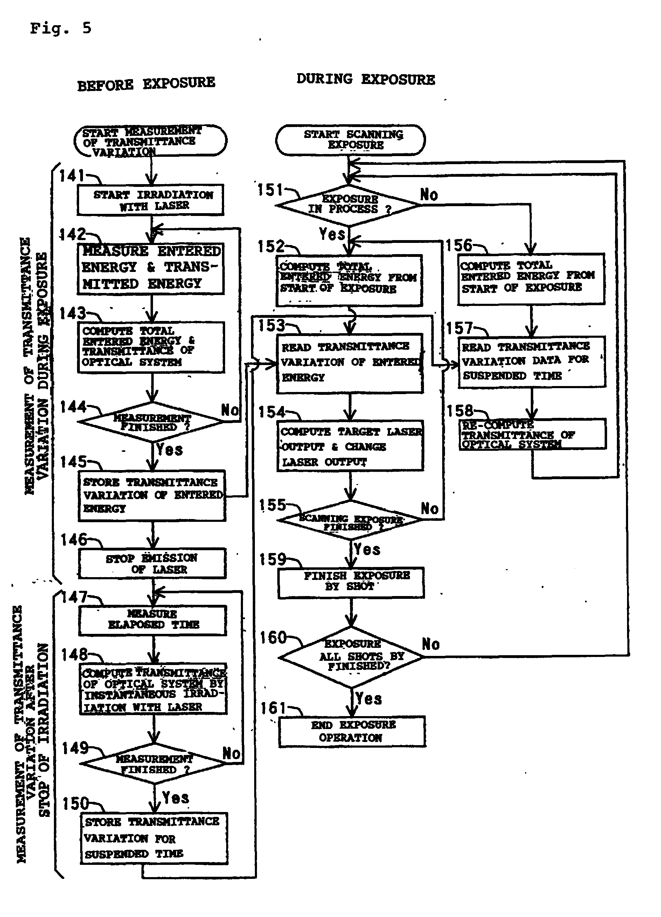

Given the foregoing background, a description will be made of the measurement operation for measuring the variation in the transmittance (attenuation factor) of the projection optical system PL and the scanning exposure operation for performing the scanning exposure in accordance with this embodiment of the present invention, with reference to the flow chart as shown in Figure 5. In this embodiment, first, at steps 141 to 145, the variation in the transmittance (attenuation factor) of the projection optical system PL is measured during the irradiation with the ultraviolet pulse light IL, the transmittance (attenuation factor) T(e) is given as a function of the total entered energy e, and the function T(e) is stored in the memory 68, in substantially the same manner as at steps 121 to 127, respectively, according to the first embodiment of the present invention as described above (or at steps 121 to 127. respectively, according to the second embodiment). Then, at steps 147 to 150, the variation in the transmittance (attenuation factor) of the projection optical system PL is measured in cases where no irradiation is performed, and the variation is represented as a function of the elapsed time.

More specifically, at step 146, the emission of the ultraviolet pulse light IL is suspended in such a state that the projection optical system PL is irradiated with the ultraviolet pulse light IL, for example, at the exposure quantity set by adding a predetermined margin to the largest possible exposure quantity that can be assumed. Thereafter, at step 147, the elapsed time t is measured from the suspension of the emission, and the transmittance (attenuation factor) T (=Eo/Ei) of the projection optical system PL is calculated at predetermined time intervals by means of the direct transmittance (attenuation factor) computation part 63 from the transmitted energy Eo and the entered energy Ei by performing the instantaneous emission of a pulse light from the ArF excimer laser light source 1 having the least pulse number at step 148, as shown in Figure 2. Then, the calculated transmittance (attenuation factor) T is supplied to the transmittance (attenuation factor) computation part 67. This measurement of the transmittance is repeated in a predetermined number of times and, when the measurement is finished, the operation is shifted from step 149 to step 150. Thereafter, at step 150, the transmittance (attenuation factor) computation part 67 approximates the transmittance (attenuation factor) T of the projection optical system PL as a function T(t) of the elapsed time t from the suspension of the emission of the ultraviolet pulse light IL and stores the function T(t) in the memory 68. As the function T(t), there may be used various functions including a function of second order or higher order of the elapsed time t having a previously non-determined coefficient, or an exponential function.

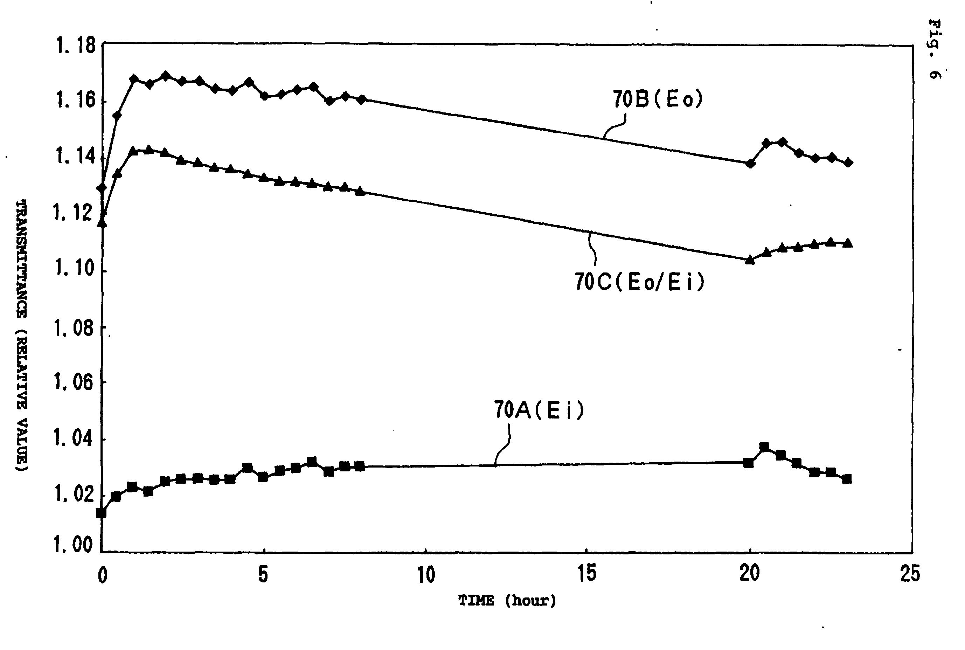

As shown in Figure 6, a curved line 70C indicates an example of the variation in the transmittance (attenuation factor) T (= Eo/Ei) of the projection optical system PL after suspension of the irradiation with the ultraviolet pulse light IL. In Figure 6, the axis of abscissas represents the elapsed time t (in hours) elapsed from suspension of the irradiation, and the axis of ordinates represents the transmittance (attenuation factor) T (relative value). A curved line 70A indicates the entered energy Ei (relative value) supplied instantaneously for measurement of the transmittance. A curved line 70B indicates the transmitted energy Eo (relative value) measured in correspondence with the entered energy Ei. As is apparent from the curved line 70C, the transmittance (attenuation factor) T of the projection optical system PL is lowered gradually, once it has been recovered to a great extent after suspension of the irradiation with the ultraviolet pulse light IL. The memory 68 stores the function T(t) of the elapsed time t that is obtained by approximating the curved line 70C.

Upon performing the scanning exposure thereafter, the main control system 27 as shown in Figure 1 supplies to the transmittance (attenuation factor) computation part 67 information indicative of the event that the ultraviolet pulse light IL is in the process of irradiating or that the irradiation with the ultraviolet pulse light IL is interrupted, for instance, due to the stepping between shots in process. Further, the transmittance (attenuation factor) computation part 67 may determine tether the ultraviolet pulse light IL is being irradiated on the basis of the presence or absence of the entered energy Ei from the ADC 62. Then, at step 151 of Figure 5, the transmittance (attenuation factor) computation part 67 determines whetizer the irradiation with the ultraviolet pulse light IL is in process or not in the manner as described above, and the total entered energy e from the entered light quantity integration part 64 is incorporated at predetermined time intervals at step 152 when the irradiation is in process. Further, at step 153, the current transmittance (attenuation factor) T(now) of the projection optical system PL is given from this total entered energy e and the function T(e) stored in the memory 68 at step 144. Thereafter, at step 154, the output of the ultraviolet pulse light IL is controlled so as to offset the variation in the transmittance (attenuation factor) T(now) in substantially the same manner as at step 110 of Figure 3, and the operations at steps 152 to 154 are repeated until the scanning exposure is finished at step 155.

After the scanning exposure has been finished at step 155 and the exposure of one shot area has been finished at step 159, then it is determined to learn whether the exposure of the whole shot areas has been finished at step 160. When it is decided that the exposure of the whole shot areas is not yet finished, then the process is returned to step 151. In this case, the wafer stage 24 is in the process of stepping in order to transfer the next shot area to the position at which the scanning is to be started and the irradiation with the ultraviolet pulse light IL is interrupted, so that the operation is shifted from step 151 to step 156 at which the transmittance (attenuation factor) computation part 67 initially calculates a current transmittance (attenuation factor) TA of the projection optical system PL from the total entered energy e supplied from the entered light quantity integration part 64 at that point of time and from the function T(e) stored at step 145. Then, the transmittance (attenuation factor) computation part 67 calculates a current transmittance (attenuation factor) TB of the projection optical system PL at step 157 from the elapsed time t elapsed so far from the interruption of the irradiation with the ultraviolet pulse light IL and from the function T(t) stored at step 150, immediately before the start of the scanning exposure of the next shot area. In this case, when the value of the transmittance (attenuation factor) T(0) at the elapsed time t being zero is set as TC, the transmittance (attenuation factor) computation part 67 calculates the current actual transmittance (attenuation factor) T(now) of the projection optical system PL at step 158 from the following formula as an example:

$$T(now) = TA \times TB/TC \qquad (5).$$

Then, as the operation is shifted from step 151 to step 152 after the start of the scanning exposure of the next shot area, the exposure quantity is controlled by setting the initial value of the transmittance (attenuation factor) of the projection optical system PL to be the value determined by the formula (5) above. The scanning exposure of each shot area is performed in the manner as described above, and the exposing operation is finished at step 161 as the exposure of the whole shot areas has been finished at step 160.

In accordance with this embodiment as described above, the exposure quantity to each shot area on the wafer W can be controlled with higher precision because the fluctuation in the transmittance (attenuation factor) of the projection optical system PL upon interruption of the irradiation with the ultraviolet pulse light IL between shots is also taken into consideration.

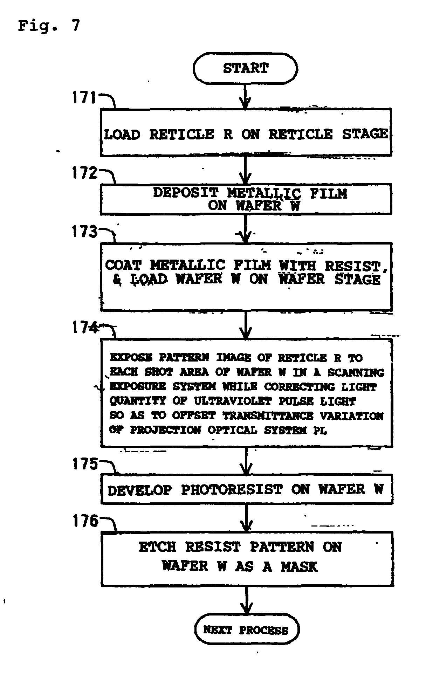

Next, a description will be made of an example of the operation to be applied to the process for actually forming a circuit pattern on a wafer W by means of scanning exposure as shown in Figure 5 with reference to the flow chart as shown in Figure 7. First, at step 171, a reticle R is loaded on a reticle stage 20A as shown in Figure 1. Then, at step 172, a metallic film is deposited on a wafer (wafer W) as an object to be exposed. Thereafter, at step 173, the metallic film deposited on the wafer W is coated with a resist, and the wafer W is loaded on a wafer stage 24 of the projection exposure apparatus as shown in Figure 1. Further, at step 174, an image of a pattern formed on the reticle R is exposed to each shot area on the wafer W, while the light quantity of the ultraviolet pulse light IL is being controlled so as to offset the variation in the transmittance (attenuation factor) of the projection optical system PL, that is, so as to maintain the illuminance of the ultraviolet pulse light IL on the wafer W at a constant level, in substantially the same manner as the operations carried out at steps 151 to 161 as shown in Figure 5.

Thereafter, the resist on the wafer W is developed at step 175 and the metallic film deposited on the wafer W is subjected to etching by using the resist pattern as a mask, at step 176. Then, the resist pattern is removed to form a desired circuit pattern in each shot area on the wafer W. The wafer W is then transferred to the process for forming a circuit pattern of a next layer. Upon this process, in this embodiment of the present invention, the optimal exposure quantity for each shot area on the wafer W is achieved, so that the desired circuit pattern can be formed in each shot area on the wafer W with a high fidelity of transcription.

It is to be noted herein that, although the above embodiments of the present invention are applied to the projection exposure apparatus of a step-and-scan type, it can also be applied to exposure with a projection exposure apparatus (stepper) of a step-and-repeat type in substantially the same manner. In the case of the stepper, however, it is preferred that the exposure time can be controlled so as to allow the integrated exposure quantity for the shot area on the wafer to reach a predetermined value, for instance, at the process corresponding to steps 110 and 111 as shown in Figure 3.

It has to be noted herein as a matter of course that the present invention is not interpreted whatsoever as being limited to the embodiments as described above and that various modifications are encompassed within the scope and spirit of this invention without departing from the gist of the invention.

The projection exposure apparatus according to the present invention is configured such that the variation in transmittance of a projection optical system is measured and stored in advance by taking advantage of the fact that the variation in the transmittance thereof demonstrates a substantially constant variation in accordance with the quantity of irradiation with light after the start of irradiation with exposing energy beams. Further, upon actual exposure, the variation in transmittance of the projection optical system is presumed from the quantity of the exposing energy beams entering into the projection optical system and the exposure quantity is controlled in accordance with the variation in the transmittance, so that the present invention offers the advantage that deterioration in precision of controlling the exposure quantity can be prevented, such deterioration resulting from the fluctuation in illuminance or in pulse energy on a substrate, which is caused to occur due to the fluctuation in the transmittance of the projection optical system.

Moreover, the projection exposure apparatus according to the present invention does not require the addition of a new sensor for measuring an exposure quantity on a substrate plane during exposure, so that a space in the vicinity of the stages on the substrate side does not undergo large limitations and can be used in an effective way.

In this case, the attenuation factor characteristic storage system, stores a rate of a variation in an attenuation factor of a projection optical system with respect to an elapsed time after interruption of the irradiation with exposing energy beams, in addition to a rate of a variation in the attenuation factor of the projection optical system with respect to the quantity of a total entered energy. On the other hand, the computation systems can presume a variation in the attenuation factor of the projection optical system with a high precision, even if the attenuation factor of the projection optical system is not yet recovered to a sufficient level after interruption of the irradiation with exposing energy beams, when the attenuation factor of the projection optical system is calculated sequentially on the basis of two kinds of the rates of variations in the attenuation factor stored in the attenuation factor characteristic storage system, the output of the entered energy quantity integration system, and the elapsed time after interruption of the irradiation with exposing energy beams.

Furthermore, when the present invention is applied to the projection exposure apparatus of a scanning exposure type such as a step-and-scan type, the projection exposure apparatus of such a scanning exposure type can achieve a favorable precision of controlling the exposure quantity by controlling the exposure quantity so as to provide a constant level of illuminance on the substrate plane for example, in accordance with the fluctuation in the attenuation factor of the projection optical system.

Moreover, the method for manufacturing the projection exposure apparatus according to the present invention offers the advantages that, as the attenuation factor of the projection optical system is measured by means of the projection exposure apparatus of a scanning exposure type according to the present invention in such a state that a mask is actually used upon measurement for the variation in the attenuation factor of the projection optical system, an occurrence of an error in measuring the variation in the attenuation factor of the projection optical system due to the fluctuation in the entered energy quantity being caused to occur on account of a difference in a density of patterns on the mask can be prevented, and precision in controlling the exposure quantity can be improved.

In addition, the method for manufacturing the circuit device according to the present invention provides the advantage that a circuit pattern can be formed on a substrate with a high fidelity of transcription by using the projection exposure apparatus according to the present invention.

## Claims

1. A projection exposure apparatus which irradiates a pattern formed on a mask with a predetermined exposing energy beam and which projects an image of the pattern on the mask onto a substrate through a projection optical system, comprising:

   an attenuation factor characteristic storage system which stores a fluctuation in an attenuation factor of the projection optical system in accordance with a total entered energy entering into the projection optical system; and
   an attenuation factor acquisition system which calculates the total entered energy entering into the projection optical system through the mask and which acquires an attenuation factor of the projection optical system upon exposure on the basis of a value of the total entering energy and on the fluctuation in the attenuation factor thereof stored in the attenuation factor characteristic storage system.

2. The projection exposure apparatus as claimed in claim 1, wherein:

   the fluctuation in the attenuation factor is a function of the value of the total entered energy entering into the projection optical system through the mask.

3. The projection exposure apparatus as claimed in claim 1, wherein:

   the total entered energy entering into the projection optical system through the mask is calculated on the basis of a transmittance of the mask.

4. The projection exposure apparatus as claimed in claim 1, wherein:

   the projection exposure apparatus projects the image of the pattern on the mask onto the substrate by relatively scanning the mask with the exposing energy beam.

5. The projection exposure apparatus as claimed in claim 4, wherein:

   the total entered energy entering into the projection optical system through the mask is calculated by using information on a relative position of the exposing energy beam and the mask.

6. The projection exposure apparatus as claimed in claim 4, wherein:

   the information on the relative position is an optical characteristic of the mask in accordance with the relative position of the exposing energy beam and the mask.

**7.** The projection exposure apparatus as claimed in claim 6, wherein:

the optical characteristic of the mask contains a characteristic of the transmittance of the mask.

**8.** The projection exposure apparatus as claimed in claim 1, further comprising:

an entering energy measurement system which measures the total entered energy entering into the projection optical system through the mask.

**9.** The projection exposure apparatus as claimed in claim 8, further comprising:

a leaving energy measurement system which measures a leaving energy leaving from the projection optical system.

**10.** The projection exposure apparatus as claimed in claim 9, wherein:

the fluctuation in the attenuation factor is given on the basis of results of measurement of the entering energy measurement system and the leaving energy measurement system.

**11.** The projection exposure apparatus as claimed in claim 8, wherein:

the entering energy measurement system measures the total entered energy entering into the projection optical system through the mask in a state in which the exposing energy beam and the mask are transferred relatively to each other.

**12.** The projection exposure apparatus as claimed in claim 8, wherein:

the projection exposure apparatus is to project the image of the pattern formed on the mask on the substrate by relatively scanning the mask with the exposing energy beam; and the total entered energy entering into the projection optical system through the mask is measured while relatively scanning the mask with the exposing energy beam in a manner like upon exposure.

**13.** The projection exposure apparatus as claimed in claim 1, further comprising:

an exposure control system which controls an exposure quantity to be provided on the substrate on the basis of the fluctuation in the attenuation factor.

**14.** The projection exposure apparatus as claimed in claim 13, wherein:

the attenuation factor characteristic storage system stores an attenuation factor of the projection optical system for the total entering energy as well as a fluctuation in the attenuation factor of the projection optical system for an elapsed time after suspension of irradiation of the projection optical system with the exposing energy beam.

**15.** The projection exposure apparatus as claimed in claim 14, wherein:

the attenuation factor of the projection optical system is given on the basis of two kinds of fluctuations in the attenuation factor stored in the attenuation factor characteristic storage system, the total entered energy entering into the projection optical system, and the elapsed time.

**16.** The projection exposure apparatus as claimed in claim 15, wherein:

the exposure quantity to be provided on the substrate is controlled on the basis of the given attenuation factor.

**17.** The projection exposure apparatus as claimed in claim 4, further comprising:

a stage system which transfers each of the mask and the substrate;
wherein the mask and the substrate are scanned through the stage system in synchronization with the projection optical system upon exposure.

**18.** The projection exposure apparatus as claimed in claim 1, wherein:

the exposing energy beam is an energy beam having a wavelength in an ultraviolet region.

**19.** A projection exposure apparatus which irradiates a pattern formed on a mask with a predetermined exposing energy beam and which projects an image of the pattern on the mask onto a substrate through a projection optical system, comprising:

an attenuation factor characteristic storage system which stores a fluctuation in an attenuation factor of the projection optical system in accordance with a total entered energy entering into the projection optical system through the mask.

20. The projection exposure apparatus as claimed in claim 19, wherein:

the fluctuation in the attenuation factor is a function of a value of the total entered energy entering into the projection optical system through the mask.

21. The projection exposure apparatus as claimed in claim 19, wherein:

the total entered energy entering into the projection optical system through the mask is calculated on the basis of a transmittance of the mask.

22. The projection exposure apparatus as claimed in claim 19, wherein:

the projection exposure apparatus projects the image of the pattern on the mask onto the substrate by relatively scanning the mask with the exposing energy beam.

23. The projection exposure apparatus as claimed in claim 22, wherein:

the total entered energy entering into the projection optical system through the mask is calculated by using information on a relative position of the exposing energy beam and the mask.

24. The projection exposure apparatus as claimed in claim 22, wherein:

the information on the relative position is an optical characteristic of the mask in accordance with the relative position of the exposing energy beam and the mask.

25. The projection exposure apparatus as claimed in claim 24, wherein:

the optical characteristic of the mask contains a characteristic of the transmittance of the mask.

26. The projection exposure apparatus as claimed in claim 19, further comprising:

an entering energy measurement system which measures the total entered energy entering into the projection optical system through the mask.

27. The projection exposure apparatus as claimed in claim 26, wherein:

the entering energy measurement system measures the total entered energy entering into the projection optical system through the mask in a state in which the exposing energy beam and the mask are transferred relatively to each other.

28. The projection exposure apparatus as claimed in claim 27, wherein:

the projection exposure apparatus is to project the image of the pattern formed on the mask onto the substrate by relatively scanning the mask with the exposing energy beam; and the total entered energy entering into the projection optical system through the mask is measured while relatively scanning the mask with the exposing energy beam in a manner like upon exposure.

29. The projection exposure apparatus as claimed in claim 19, wherein:

the exposing energy beam is an energy beam having a wavelength in an ultraviolet region.

30. A method for manufacturing a projection exposure apparatus which irradiates a pattern formed on a mask with a predetermined exposing energy beam and which projects an image of the pattern formed on the mask onto a substrate through a projection optical system, said method is characterized by the steps of:

installing an attenuation factor characteristic storage system which stores a fluctuation in an attenuation factor of the projection optical system in accordance with a total entered energy entering into the projection optical system; and installing an attenuation factor acquisition system which calculates a total entered energy entering into the projection optical system through the mask and which acquires an attenuation factor of the projection optical system upon exposure on the basis of a value of the total entering energy and on the fluctuation in the attenuation factor thereof stored in the attenuation factor characteristic storage system.

31. The method for manufacturing the projection exposure apparatus as claimed in claim 30, wherein:

a substrate is formed by using the projection exposure apparatus manufactured by the method.

**32.** The manufacturing method as claimed in claim 30, wherein:

the fluctuation in the attenuation factor is a function of the value of the total entered energy entering into the projection optical system through the mask.

**33.** The manufacturing method as claimed in claim 30, wherein:

the total entered energy entering into the projection optical system through the mask is calculated on the basis of a transmittance of the mask.

**34.** The manufacturing method as claimed in claim 30, wherein:

the total entered energy entering into the projection optical system through the mask is calculated by using information on a relative position of the exposing energy beam and the mask.

**35.** The manufacturing method as claimed in claim 34, wherein:

the information on the relative position is an optical characteristic of the mask in accordance with the relative position of the exposing energy beam and the mask.

**36.** The manufacturing method as claimed in claim 35, wherein:

the optical characteristic of the mask contains a characteristic of the transmittance of the mask.

**37.** The manufacturing method as claimed in claim 30, further comprising:

installing an entering energy measurement system which measures the total entered energy entering into the projection optical system through the mask.

**38.** The manufacturing method as claimed in claim 30, further comprising:

installing a leaving energy measurement system which measures the leaving energy leaving from the projection optical system.

**39.** The manufacturing method as claimed in claim 30, further comprising:

installing an exposure control system which controls an exposure quantity to be provided on the substrate on the basis of the fluctuation in the attenuation factor.

**40.** The manufacturing method as claimed in claim 30, wherein:

the exposing energy beam is an energy beam having a wavelength in an ultraviolet region.

**41.** An exposure method for irradiating a pattern formed on a mask with a predetermined exposing energy beam and projecting an image of the pattern formed on the mask onto a substrate through a projection optical system, comprising:

obtaining a fluctuation in an attenuation factor of the projection optical system in accordance with a total entered energy entering into the projection optical system; and obtaining an attenuation factor of the projection optical system on the basis of a value of a total entered energy entering into the projection optical system through the mask and on the fluctuation in the attenuation factor thereof.

**42.** The exposure method as claimed in claim 41, wherein:

the total entered energy entering into the projection optical system through the mask is calculated on the basis of a transmittance of the mask.

**43.** The exposure method as claimed in claim 41, wherein:

the total entered energy entering into the projection optical system through the mask is calculated by using information on a relative position of the exposing energy beam and the mask.

**44.** The exposure method as claimed in claim 43, wherein:

the information on the relative position is an optical characteristic of the mask in accordance with the relative position of the exposing energy beam and the mask.

**45.** The exposure method as claimed in claim 44, wherein:

the optical characteristic of the mask contains a characteristic of the transmittance of the mask.

**46.** The exposure method as claimed in claim 41, wherein:

the total entered energy entering into the projection optical system through the mask is measured in a state in which the exposing energy beam and the mask are transferred relatively to each other.

**47.** The exposure method as claimed in claim 41, further comprising:

controlling an exposure quantity to be provided on the mask on the basis of the fluctuation in the attenuation factor.

**48.** The exposure method as claimed in claim 41, wherein:

the fluctuation in the attenuation factor of the projection optical system is given by using two types of the fluctuation, one type is the fluctuation of the projection optical system for the total entering energy, the other type is the fluctuation of the projection optical system for an elapsed time after irradiation of the projection optical system with the exposing energy beam is suspended.

**49.** The exposure method as claimed in claim 41, wherein:

the exposing energy beam is an energy beam having a wavelength in an ultraviolet region.

**50.** A method for manufacturing a circuit device by projecting an image of a pattern formed on a mask onto a substrate through a projection optical system, said method is characterized by the steps of:

coating the substrate with a photosensitive material;
exposing the image of the pattern on the mask to the substrate by controlling an exposure quantity onto the substrate on the basis of the attenuation factor of the projection optical system upon exposure, the attenuation factor being given on the basis of a fluctuation in an attenuation factor of the projection optical system for the total entered energy entering into the projection optical system through the mask and on the total entering energy; and
developing the substrate.

**51.** The exposure method as claimed in claim 50, wherein:

the total entered energy entering into the projection optical system through the mask is given on the basis of an optical characteristic of the mask in accordance with a relative position of the mask and the exposing energy beam.

**52.** An exposure method for irradiating a pattern formed on a mask with a predetermined exposing energy beam and projecting an image of the pattern formed on the mask onto a substrate through a projection optical system, comprising:

obtaining a fluctuation in an attenuation factor of the projection optical system in accordance with a total entered energy entering into the projection optical system;
correcting the total entered energy entering into the projection optical system on the basis of a pattern information on the pattern of the mask; and
obtaining an attenuation factor of the projection optical system on the basis of a value of the corrected total entering energy and on the fluctuation in the attenuation factor of the projection optical system.

**53.** The exposure method as claimed in claim 52, wherein:

the pattern information contains a transmittance of the mask.

**54.** The exposure method as claimed in claim 52, wherein:

the pattern information contains a rate of the presence of a pattern on the mask.

**55.** The exposure method as claimed in claim 52, wherein:

the pattern information is an optical characteristic of the mask in accordance with a relative position between the exposing energy beam and the mask.

**56.** The exposure method as claimed in claim 55, wherein:

the optical characteristic of the mask contains a characteristic of a transmittance of the mask.

**57.** The exposure method as claimed in claim 55, wherein:

the optical characteristic of the mask contains a rate of the presence of a pattern on the mask.

**58.** The exposure method as claimed in claim 52, further comprising:

controlling an exposure quantity to be provided on the substrate on the basis of the fluctuation in the attenuation factor

59. The exposure method as claimed in claim 52, wherein:

the exposing energy beam is an energy beam having a wavelength in an ultraviolet region.

60. A projection exposure apparatus which irradiates a pattern formed on a mask with a predetermined exposing energy beam and which projects an image of the pattern formed on the mask onto a substrate through a projection optical system, comprising:

an attenuation factor characteristic storage system which stores a fluctuation in an attenuation factor of the projection optical system in an elapsed time after suspension of the irradiation of the projection optical system with the exposing energy beam.

61. The projection exposure apparatus as claimed in claim 60, wherein:

the fluctuation in the attenuation factor is approximated as a function of the elapsed time after suspension of the irradiation of the mask with the exposing energy beam.

62. The projection exposure apparatus as claimed in claim 60, wherein:

the attenuation factor characteristic storage system further stores the fluctuation in the attenuation factor of the projection optical system in accordance with the total entered energy entering into the projection optical system.

63. The exposure method as claimed in claim 60, wherein:

the exposing energy beam is an energy beam having a wavelength in an ultraviolet region.

64. A method for manufacturing a projection exposure apparatus which irradiates a pattern formed on a mask with a predetermined exposing energy beam and which projects an image of the pattern formed on the mask onto a substrate through a projection optical system, said method is characterized by the steps of:

installing an attenuation factor characteristic storage system which stores a fluctuation in an attenuation factor of the projection optical system in accordance with an elapsed time after interruption of the irradiation of the projection optical system with the exposing energy beam; and

installing an attenuation factor acquisition system which acquires an attenuation factor of the projection optical system upon exposure on the basis of the fluctuation in the attenuation factor thereof stored in the attenuation factor characteristic storage system and the elapsed time.

65. The method for manufacturing the projection exposure apparatus as claimed in claim 64, wherein:

a substrate is formed by using the projection exposure apparatus manufactured by the method.

66. The manufacturing method as claimed in claim 64, further comprising:

installing an exposure control system which controls an exposure quantity to be provided on the substrate on the basis of the fluctuation in the attenuation factor.

67. The manufacturing method as claimed in claim 64, wherein:

the exposing energy beam is an energy beam having a wavelength in an ultraviolet region.

68. An exposure method for irradiating a pattern formed on a mask with a predetermined exposing energy beam and projecting an image of the pattern on the mask onto a substrate through a projection optical system, comprising:

obtaining a fluctuation in an attenuation factor of the projection optical system in an elapsed time after interruption of the irradiation of the projection optical system with the exposing energy beam; and controlling an exposure quantity on the substrate on the basis of the fluctuation in the attenuation factor.

69. The exposure method as claimed in claim 68, further comprising:

obtaining the fluctuation in the attenuation factor of the projection optical system for the total entered energy entering into the projection optical system after restarting the irradiation of the projection optical system with the exposing energy beam; and

controlling the exposure quantity on the basis of the fluctuation in the attenuation factor during the interruption and the fluctuation in the attenuation factor after resumption of the interruption.

**70.** The exposure method as claimed in claim 68, wherein:

the fluctuation in the attenuation factor after the interruption is approximated as a function of the elapsed time after suspension of the irradiation of the mask with the exposing energy beam.

**71.** The exposure method as claimed in claim 68, wherein:

the exposing energy beam is an energy beam having a wavelength in an ultraviolet region.

**72.** A method for manufacturing a circuit device by projecting an image of a pattern formed on a mask onto a substrate through a projection optical system, said method is characterized by the steps of:

coating the substrate with a photosensitive material;
exposing the image of the pattern on the mask to the substrate by controlling an exposure quantity on the substrate on the basis of the attenuation factor of the projection optical system, the attenuation factor upon exposure being given on the basis of a fluctuation in an attenuation factor of the projection optical system in a predetermined elapsed time after interruption of exposure of the mask; and developing the substrate.

**73.** The exposure method as claimed in claim 72, wherein:

the total entered energy entering into the projection optical system through the mask is given on the basis of an optical characteristic of the mask in accordance with a relative position of the mask and the exposing energy beam.

Fig. 1

EP 1 017 086 A1

Fig. 2

24

Fig. 3

BEFORE EXPOSURE

DURING EXPOSURE

Fig. 4

BEFORE EXPOSURE                    DURING EXPOSURE

```
 ( START MEASUREMENT OF  )        ( START SCANNING EXPOSURE )
 ( TRANSMITTANCE VARIATION )
           │                                 │
 121 ─┐    ▼                      128 ─┐      ▼
  ┌─────────────────┐              ┌──────────────────┐
  │   LOAD RETICLE  │              │ START IRRADIATION│
  └─────────────────┘              │   WITH LASER     │
           │                       └──────────────────┘
 122 ─┐    ▼                      129 ─┐      ▼
  ┌─────────────────┐              ┌──────────────────────┐
  │ CALL RETICLE DATA│             │ MEASURE RETICLE POSITION│
  │ & CALCULATE PATTERN│           │ & ENTERED ENERGY, &    │
  │ TRANSMITTANCE    │             │ COMPUTE TOTAL ENTERED  │
  │ CORRESPONDING TO │             │ ENERGY FROM START OF   │
  │ RETICLE POSITION │             │ EXPOSURE               │
  └─────────────────┘             └──────────────────────┘
 123 ─┐    ▼                      130 ─┐      ▼
  ┌─────────────────┐              ┌──────────────────────┐
  │ SCAN RETICLE    │              │ READ TRANSMITTANCE DATA│
  │ & START IRRADIATION│           └──────────────────────┘
  │ WITH LASER      │             131 ─┐      ▼
  └─────────────────┘              ┌──────────────────────┐
 124 ─┐    ▼◄──────┐               │ COMPUTE TARGET       │
  ┌─────────────────┐    │         │ LASER OUTPUT &       │
  │ MEASURE RETICLE POSITION,│     │ CHANGE LASER OUTPUT  │
  │ ENTERED ENERGY &  │    │       └──────────────────────┘
  │ TRANSMITTED ENERGY│    │      132 ─┐      ▼         No
  └─────────────────┘    │        ◄ SCANNING EXPOSURE ►──┐
 125 ─┐    ▼            │           ◄  FINISHED ?  ►      │
  ┌─────────────────┐    │                │ Yes          │
  │ COMPUTE TOTAL ENTERED│  │      133 ─┐  ▼              │
  │ ENERGY & TRANSMITTANCE OF│        ┌──────────────────┐│
  │ OPTICAL SYSTEM  │    │         │ STOP EMISSION OF LASER│
  └─────────────────┘    │         └──────────────────┘│
 126 ─┐    ▼         No │        134 ─┐  ▼              │
     ◄ MEASUREMENT ►────┘           ┌──────────────────┐│
     ◄ FINISHED ? ►                 │ FINISH EXPOSURE  ││
           │ Yes                    │ BY ONE SHOT      ││
 127 ─┐    ▼                        └──────────────────┘│
  ┌─────────────────┐             135 ─┐  ▼              │
  │ STORE TRANSMITTANCE│            ┌──────────────────┐│
  │ VARIATION OF ENTERED│           │ START EXPOSURE   ││
  │ ENERGY          │               │ BY NEXT SHOT     ││
  └─────────────────┘               └──────────────────┘│
           │                               │            │
           └───────────────────────────────┘            │
```

Fig. 5

BEFORE EXPOSURE          DURING EXPOSURE

Fig. 6

Fig. 7

```
                            ┌─────────────┐
                            │    START    │
                            └──────┬──────┘
   171 ─┐                          ▼
       ┌──────────────────────────────────────────────┐
       │ LOAD RETICLE R ON RETICLE STAGE               │
       └──────────────────────┬───────────────────────┘
   172 ─┐                      ▼
       ┌──────────────────────────────────────────────┐
       │          DEPOSIT METALLIC FILM               │
       │               ON WAFER W                      │
       └──────────────────────┬───────────────────────┘
   173 ─┐                      ▼
       ┌──────────────────────────────────────────────┐
       │ COAT METALLIC FILM WITH RESIST,              │
       │ & LOAD WAFER W ON WAFER STAGE                 │
       └──────────────────────┬───────────────────────┘
   174 ─┐                      ▼
       ┌──────────────────────────────────────────────┐
       │ EXPOSE PATTERN IMAGE OF RETICLE R TO         │
       │ EACH SHOT AREA OF WAFER W IN A SCANNING      │
       │ EXPOSURE SYSTEM WHILE CORRECTING LIGHT       │
       │ QUANTITY OF ULTRAVIOLET PULSE LIGHT          │
       │ SO AS TO OFFSET TRANSMITTANCE VARIATION      │
       │ OF PROJECTION OPTICAL SYSTEM PL              │
       └──────────────────────┬───────────────────────┘
   175 ─┐                      ▼
       ┌──────────────────────────────────────────────┐
       │ DEVELOP PHOTORESIST ON WAFER W               │
       └──────────────────────┬───────────────────────┘
   176 ─┐                      ▼
       ┌──────────────────────────────────────────────┐
       │        ETCH RESIST PATTERN ON                │
       │         WAFER W AS A MASK                     │
       └──────────────────────┬───────────────────────┘
                              ▼
                      ┌───────────────┐
                      │ NEXT PROCESS  │
                      └───────────────┘
```

# INTERNATIONAL SEARCH REPORT

International application No.

PCT/JP98/02840

## A. CLASSIFICATION OF SUBJECT MATTER
Int.Cl⁶ H01L21/027, G03F7/20

According to International Patent Classification (IPC) or to both national classification and IPC

## B. FIELDS SEARCHED

Minimum documentation searched (classification system followed by classification symbols)
Int.Cl⁶ H01L21/027, G03F7/20

Documentation searched other than minimum documentation to the extent that such documents are included in the fields searched

| | | | |
|---|---|---|---|
| Jitsuyo Shinan Koho | 1926–1998 | Toroku Jitsuyo Shinan Koho | 1994–1998 |
| Kokai Jitsuyo Shinan Koho | 1971–1998 | Jitsuyo Shinan Toroku Koho | 1996–1998 |

Electronic data base consulted during the international search (name of data base and, where practicable, search terms used)

## C. DOCUMENTS CONSIDERED TO BE RELEVANT

| Category* | Citation of document, with indication, where appropriate, of the relevant passages | Relevant to claim No. |
|---|---|---|
| A | JP, 1-274022, A (Nikon Corp.),<br>1 November, 1989 (15. 11. 89),<br>Claim 1 (Family: none) | 1-73 |
| A | JP, 5-343286, A (Nikon Corp.),<br>24 December, 1993 (24. 12. 93),<br>Claim 1 (Family: none) | 1-73 |

☐ Further documents are listed in the continuation of Box C.   ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | | |
| "O" | document referring to an oral disclosure, use, exhibition or other means | "Y" | document of particular relevance; the claimed invention cannot be considered to involve an inventive step when the document is combined with one or more other such documents, such combination being obvious to a person skilled in the art |
| "P" | document published prior to the international filing date but later than the priority date claimed | "&" | document member of the same patent family |

| Date of the actual completion of the international search | Date of mailing of the international search report |
|---|---|
| 17 September, 1998 (17. 09. 98) | 29 September, 1998 (29. 09. 98) |

| Name and mailing address of the ISA/ | Authorized officer |
|---|---|
| Japanese Patent Office | |
| Facsimile No. | Telephone No. |

Form PCT/ISA/210 (second sheet) (July 1992)